# EUROPEAN PATENT APPLICATION

(11) **EP 4 343 827 A1**
(43) Date of publication of application: **27.03.2024**
(21) Application number: 22196903.3
(22) Date of filing: 21.09.2022
(51) Int. Cl.: H01L 23/00, H01L 25/00

(54) **METHOD AND APPARATUS FOR BONDING SUBSTRATES**

(71) Applicant: ASML Netherlands B.V., 5500 AH Veldhoven (NL)
(72) Inventor: PARAYIL VENUGOPALAN, Syam, 5500 AH Veldhoven (NL); RAVICHANDRAN, Arvind, 5500 AH Veldhoven (NL)
(74) Representative: ASML Netherlands B.V.

(57) **Abstract**

A device for aligning and placing electrical components includes a first stage to support at least one first electrical component, each first electrical component having a plurality of conductive surfaces on a side opposite the first stage, a second stage to support at least one second electrical component, each second electrical component having a plurality of conductive surfaces on a side opposite the second stage, a voltage source to produce a voltage between the conductive surfaces of the first electrical components and conductive surfaces of the second electrical components, and a controller to control relative motion between the first stage and the second stage, and to align corresponding ones of the plurality of conductive surfaces of the first electrical component with corresponding ones of the plurality of conductive surfaces on the second electrical component at least partially on the basis of an electrostatic force therebetween.

## Description

### FIELD

The description herein relates generally to systems and methods for bonding two substrates. More particularly, it relates to the use of electric fields to determine proper alignment between two substrates to be bonded.

### BACKGROUND

A lithography apparatus can be used, for example, in the manufacture of integrated circuits (ICs). In such a case, a patterning device (e.g., a mask) may contain or provide a device pattern corresponding to an individual layer of the IC ("design layout"), and this pattern can be transferred onto a target portion (e.g. comprising one or more dies) on a substrate (e.g., silicon wafer) that has been coated with a layer of radiation-sensitive material ("resist"), by methods such as irradiating the target portion through the pattern of the patterning device. In general, a single substrate contains a plurality of adjacent target portions to which the pattern is transferred successively by the lithography apparatus, one target portion at a time. In one type of lithography apparatuses, the pattern of the entire patterning device is transferred onto one target portion in one go; such an apparatus is commonly referred to as a stepper. In an alternative apparatus, commonly referred to as a step-and-scan apparatus, a projection beam scans over the patterning device in a given reference direction (the "scanning" direction) while synchronously moving the substrate parallel or anti-parallel to this reference direction. Different portions of the pattern of the patterning device are transferred to one target portion progressively. Since, in general, the lithography apparatus will have a magnification factor M (generally < 1), the speed F at which the substrate is moved will be a factor M times that at which the projection beam scans the patterning device.

Prior to transferring the pattern from the patterning device to the substrate, the substrate may undergo various procedures, such as priming, resist coating and a soft bake. After exposure, the substrate may be subjected to other procedures, such as a post-exposure bake (PEB), development, a hard bake and measurement/inspection of the transferred pattern. This array of procedures is used as a basis to make an individual layer of a device, e.g., an IC. The substrate may then undergo various processes such as etching, ion-implantation (doping), metallization, oxidation, chemo-mechanical polishing, etc., all intended to finish off the individual layer of the device. If several layers are required in the device, then the whole procedure, or a variant thereof, is repeated for each layer. Eventually, a device will be present in each target portion on the substrate. These devices are then separated from one another by a technique such as dicing or sawing, whence the individual devices can be mounted on a carrier, connected to pins, etc.

Thus, manufacturing devices, such as semiconductor devices, typically involves processing a substrate (e.g., a semiconductor wafer) using a number of fabrication processes to form various features and multiple layers of the devices. Such layers and features are typically manufactured and processed using, e.g., deposition, lithography, etch, chemical-mechanical polishing, and ion implantation. Multiple devices may be fabricated on a plurality of dies on a substrate and then separated into individual devices. This device manufacturing process may be considered a patterning process. A patterning process involves a patterning step, such as optical and/or nanoimprint lithography using a patterning device in a lithographic apparatus, to transfer a pattern of the patterning device to a substrate and typically, but optionally, involves one or more related pattern processing steps, such as resist development by a development apparatus, baking of the substrate using a bake tool, etching using the pattern using an etch apparatus, etc.

When assembling electronic devices from multiple substrates, a bonding operation is used. For example, a first substrate having a plurality of conductive pads may need to be attached to a second substrate having a corresponding plurality of conductive pads. In order for the assembled device to work properly, the corresponding pairs of pads should be assembled in registry with one another such that there is electrical contact between desired pairs of conductors on the two devices.

### SUMMARY

In an embodiment, a device for aligning and placing electrical components includes a first stage, the first stage configured and arranged to support in use at least one first electrical component, each first electrical component having a plurality of conductive surfaces on a side distal from the first stage, a second stage, the second stage configured and arranged to support at least one second electrical component, each second electrical component having a plurality of conductive surfaces on a side distal from the second stage, a voltage source, configured and arranged to produce a voltage between the conductive surfaces of the first electrical components and conductive surfaces of the second electrical components, a controller, configured and arranged to control relative motion between the first stage and the second stage, and to align corresponding ones of the plurality of conductive surfaces of the first electrical component with corresponding ones of the plurality of conductive surfaces on the second electrical component at least partially on the basis of an electrostatic force therebetween..

In an embodiment, a method of aligning and placing electrical components using a first stage supporting at least one first electrical component and a second stage supporting at least one second electrical component, each first electrical component having at least one conductive surface on a side distal from the first stage and each second electrical component having a at least one conductive surface on a side distal from the second stage, includes applying a voltage between the at least one conductive surface of the at least one first electrical component and the at least one conductive surface of the at least one second electrical component, controlling relative motion between the first stage and the second stage, to perform an alignment between corresponding ones of the conductive surfaces on the basis of an electrostatic force therebetween.

In an embodiment, there is provided a computing system including a processor and a memory, and including a non-transitory machine readable medium including instructions for performing the foregoing method.

In an embodiment, there is provided a computer program product including a computer non-transitory readable medium having instructions recorded thereon, the instructions when executed by a computer implementing the foregoing method.

### BRIEF DESCRIPTION OF THE DRAWINGS

Figure 1 illustrates a schematic diagram of a lithography apparatus;
Figure 2 depicts an embodiment of a lithographic cell or cluster;
Figure 3 is a schematic illustration of a die alignment device in accordance with an embodiment;
Figure 4 is a schematic illustration of an embodiment of a holder that is incorporated into a die alignment device in accordance with an embodiment;
Figure 5 is a schematic illustration of an electrostatic chuck in accordance with an embodiment;
Figures 6a and 6b schematically illustrate two embodiments of peripheral alignment markers for use in an alignment operation in accordance with an embodiment;
Figure 7a is a flowchart illustrating a process in accordance with an embodiment;
Figure 7b is a flowchart illustrating a process in accordance with an embodiment;
Figure 8 is a graph of attractive force vs distance; and
Figure 9 is an illustration of a meandering scan path to be used during an alignment process.

### DETAILED DESCRIPTION OF THE DRAWINGS

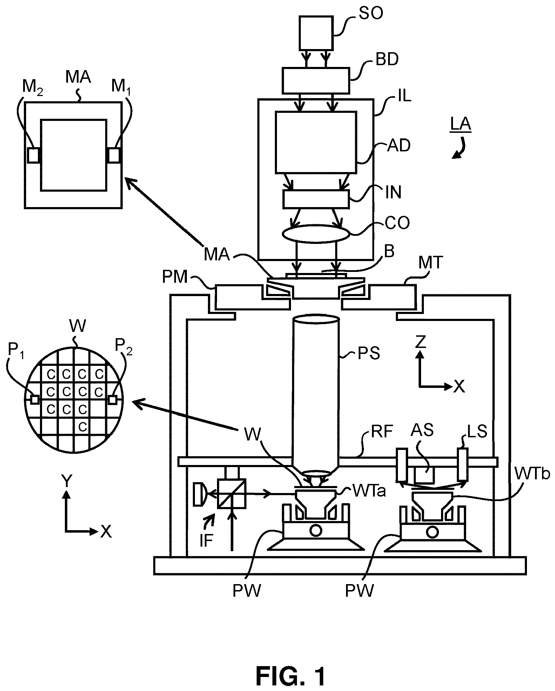

Figure 1 schematically depicts a lithographic apparatus LA in association with which the techniques described herein can be utilized. The apparatus includes an illumination optical system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; one or more substrate tables (e.g., a wafer table) WTa, WTb constructed to hold a substrate (e.g., a resist coated wafer) W and connected to a second positioner PW configured to accurately position the substrate in accordance with certain parameters; and a projection optical system (e.g., a a refractive, catoptric or catadioptric optical system) PS configured to project a pattern imparted to the radiation beam B by patterning device MA onto a target portion C (e.g., including one or more dies) of the substrate W.

The illumination optical system may include various types of optical components, such as refractive, reflective, magnetic, electromagnetic, electrostatic or other types of optical components, or any combination thereof, for directing, shaping, or controlling radiation. In this particular case, the illumination system also comprises a radiation source SO.

The patterning device support holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support may be a frame or a table, for example, which may be fixed or movable as required. The patterning device support may ensure that the patterning device is at a desired position, for example with respect to the projection system. Any use of the terms "reticle" or "mask" herein may be considered synonymous with the more general term "patterning device."

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

The patterning device may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam, which is reflected by the mirror matrix.

As here depicted, the apparatus is of a transmissive type (e.g., employing a transmissive patterning device). However, the apparatus may be of a reflective type (e.g., employing a programmable mirror array of a type as referred to above, or employing a reflective mask). The apparatus may employ a different kind of patterning device to classic mask; examples include a programmable mirror array or LCD matrix.

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems. The term "immersion" as used herein does not mean that a structure, such as a substrate, must be submerged in liquid, but rather only means that liquid is located between the projection system and the substrate during exposure.

Referring to Figure 1, the illuminator IL receives a radiation beam from a radiation source SO (e.g., a mercury lamp or excimer laser, LPP (laser produced plasma) EUV source). The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may include an adjuster AD for adjusting the spatial and/or angular intensity distribution of the radiation beam. Generally, at least the outer and/or inner radial extent (commonly referred to as α-outer and α-inner, respectively) of the intensity distribution in a pupil plane of the illuminator can be adjusted. In addition, the illuminator IL may include various other components, such as an integrator IN and a condenser CO. The illuminator may be used to condition the radiation beam, to have a desired uniformity and intensity distribution in its cross section.

The radiation beam B is incident on the patterning device (e.g., mask) MA, which is held on the patterning device support (e.g., mask table) MT, and is patterned by the patterning device. Having traversed the patterning device (e.g., mask) MA, the radiation beam B passes through the projection optical system PS, which focuses the beam onto a target portion C of the substrate W, thereby projecting an image of the pattern on the target portion C. With the aid of the second positioner PW and position sensor IF (e.g., an interferometric device, linear encoder, 2-D encoder or capacitive sensor), the substrate table WT can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

Patterning device (e.g., mask) MA and substrate W may be aligned using patterning device alignment marks M₁, M₂ and substrate alignment marks P₁, P₂. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the patterning device alignment marks may be located between the dies. Small alignment markers may also be included within dies, in amongst the device features, in which case it is desirable that the markers be as small as possible and not require any different imaging or process conditions than adjacent features. The alignment system, which detects the alignment markers, is described further below.

Lithographic apparatus LA in this example is of a so-called dual stage type which has two substrate tables WTa, WTb and two stations - an exposure station and a measurement station - between which the substrate tables can be exchanged. While one substrate on one substrate table is being exposed at the exposure station, another substrate can be loaded onto the other substrate table at the measurement station and various preparatory steps carried out. The preparatory steps may include mapping the surface control of the substrate using a level sensor LS, measuring the position of alignment markers on the substrate using an alignment sensor AS, performing any other type of metrology or inspection, etc. This enables a substantial increase in the throughput of the apparatus. More generally, the lithography apparatus may be of a type having two or more tables (e.g., two or more substrate tables, a substrate table and a measurement table, two or more patterning device tables, etc.). In such "multiple stage" devices a plurality of the multiple tables may be used in parallel, or preparatory steps may be carried out on one or more tables while one or more other tables are being used for exposures. Twin stage lithography apparatuses are described, for example, in U.S. Patent No. 5,969,441, incorporated herein by reference in its entirety.

While a level sensor LS and an alignment sensor AS are shown adjacent substrate table WTb, it will be appreciated that, additionally or alternatively, a level sensor LS and an alignment sensor AS can be provided adjacent the projection system PS to measure in relation to substrate table WTa.

The depicted apparatus can be used in a variety of modes, including for example a step mode or a scan mode. The construction and operation of lithographic apparatus is well known to those skilled in the art and need not be described further for an understanding of the embodiments of the present invention.

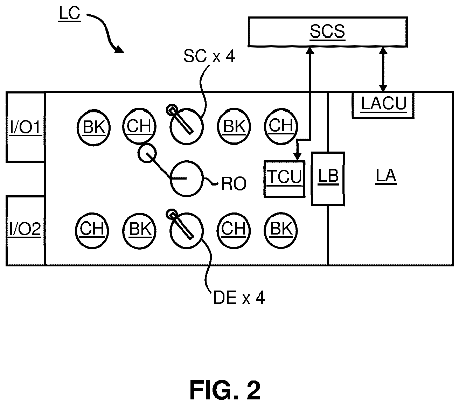

As shown in Figure 2, the lithographic apparatus LA forms part of a lithographic system, referred to as a lithographic cell LC or a lithocell or cluster. The lithographic cell LC may also include apparatus to perform pre- and post-exposure processes on a substrate. Conventionally these include spin coaters SC to deposit resist layers, developers DE to develop exposed resist, chill plates CH and bake plates BK. A substrate handler, or robot, RO picks up substrates from input/output ports I/O1, I/O2, moves them between the different process apparatus and delivers then to the loading bay LB of the lithographic apparatus. These devices, which are often collectively referred to as the track, are under the control of a track control unit TCU which is itself controlled by the supervisory control system SCS, which also controls the lithographic apparatus via lithography control unit LACU. Thus, the different apparatus can be operated to maximize throughput and processing efficiency.

The patterning device referred to above comprises, or can form, one or more design layouts or patterns (hereinafter design pattern for convenience). The design pattern can be generated utilizing CAD (computer-aided design) programs, this process often being referred to as EDA (electronic design automation). Most CAD programs follow a set of predetermined design rules in order to create functional design patterns/patterning devices. These rules are set by processing and design limitations. For example, design rules define the space tolerance between circuit devices (such as gates, capacitors, etc.) or interconnect lines, so as to ensure that the circuit devices or lines do not interact with one another in an undesirable way. One or more of the design rule limitations may be referred to as "critical dimensions" (CD). A critical dimension of a circuit can be defined as the smallest width of a line or hole or the smallest space between two lines or two holes. Thus, the CD determines the overall size and density of the designed circuit. Of course, one of the goals in integrated circuit fabrication is to faithfully reproduce the original circuit design on the substrate (via the patterning device).

The illumination system provides illumination (i.e., radiation) in the form of an illumination mode to a patterning device and the projection system directs and shapes the illumination, via the patterning device, onto a substrate via aerial image (AI). The illumination mode defines the characteristics of the illumination, such as the angular or spatial intensity distribution (e.g., conventional, dipole, annular, quadrupole, etc.), an illumination sigma (a) setting, etc. The aerial image (AI) is the radiation intensity distribution at substrate level. A resist layer on the substrate is exposed and the aerial image is transferred to the resist layer as a latent "resist image" (RI) therein. The resist image (RI) can be defined as a spatial distribution of solubility of the resist in the resist layer.

A set of conditions for imaging can be considered, and of the total set of possible conditions, a process window of a pattern is a space in that set of conditions in which processing parameters for producing the pattern are such that satisfactory imaging of the pattern is achieved. That is, for a given pattern, there may be a set of values of depth of focus, illumination intensity, illumination pattern, numerical aperture, and other controllable variables produce images having sufficiently good imaging of lines or features including linewidth, pitch, or other aspects of the imaged pattern that are defined as meeting the specifications for the required imaging. The process window gives an indication of the process sensitivity to variations in input parameters such as radiation dose.

Processing parameters are parameters of the patterning process. The patterning process may include processes upstream and downstream to the actual lithographic transfer of the pattern. Processing parameters may belong to a number of categories. A first category may be parameters of the lithography apparatus or any other apparatuses used in the patterning process. Examples of this category include parameters of the illumination system, projection system, substrate stage, etc. of a lithography apparatus. A second category may be parameters of any procedures performed in the patterning process. Examples of this category include focus, dose, bandwidth, exposure duration, development temperature, chemical compositions used in development, etc. A third category may be parameters of the design pattern. Examples of this category may include resolution enhancement technique (RET) or optical proximity correction adjustments such as shapes and/or locations of assist features. A fourth category may be parameters of the substrate. Examples include characteristics of structures under a resist layer, chemical composition of the resist layer, and/or physical dimensions of the resist layer. A fifth category may be parameters that represent a characteristic of temporal variation of one or more parameters of the patterning process. Examples of this category may include a characteristic of high frequency stage movements (e.g., frequency, amplitude, etc.), a high frequency laser bandwidth change (e.g., frequency, amplitude, etc.) and/or a high frequency laser wavelength change. These high frequency changes or movements are those above the response time of a mechanism to adjust the underlying parameter (e.g., stage position, laser intensity, etc.). A sixth category may be a characteristic upstream or downstream to exposure, such as post-exposure bake (PEB), development, etching, deposition, resist application, doping and/or packaging.

After the manufacturing steps, but before final packaging steps, a dice step is typically performed. Dicing may be done by any of several mechanism, including conventional dicing saw, plasma assisted dicing, or laser dicing, which may be conventional or stealth (i.e., ablation occurs within the bulk portion of the wafer rather than at a surface). Whichever method is used, the wafer is cut into dozens of desired final chip-sized dice. Cutting takes place along scribe lanes, which should be laid out with particular restrictions such as avoiding active regions or metal lines that cross them. Often scribe lanes will include printed features such as alignment marks or the like, that are pertinent to the imaging processes, but not to the final resulting chip. In an embodiment, plasma assisted dicing is used because it is able to provide very precise cutting, and smooth edges to the dies, which allow for a relatively more precise mechanical alignment in an initial step as discussed in greater detail below.

Included in the broad category of packaging is assembly of multiple substrate devices. As technology progresses to advanced nodes, it is useful to increase the performance of the resulting microprocessors by innovations in scaling at dimensional, device, circuit and architectural levels. It has become challenging to improve the performance per dollar with upcoming nodes because the boost brought by the dimensional, device and circuit level scaling engines are plateauing. Thus, 3D stacking has become a promising candidate to continue finding improvement.

Building 3D structures generally involves wafer to wafer stacking and subsequently bonding operations, and such stacking and bonding has been an important manufacturing step in production of, for example, CMOS image sensors and 3DNAND devices. It has also been considered to stack memory directly on logic, to reduce the bottleneck resulting from having to incorporate a bus between memory and logic functions within a device (the Von Neumann bottleneck).

Thus, stacking can include memory on memory, logic on logic, or memory on logic. In each case, one, or more, die is stacked onto another. The two dies may be interconnected (bonded) by through silicon vias (TSVs) or by other suitable contact pads available on the individual dies. Using this 3D stacking approach, performance per dollar may continue to increase without necessarily shrinking the dimensions of the individual functional elements of the device.

Therefore, the inventors have recognized a need for high speed stacking tools that can also produce excellent alignment accuracy. Current tools for this purpose tend to be either high-accuracy or high-volume, but not both.

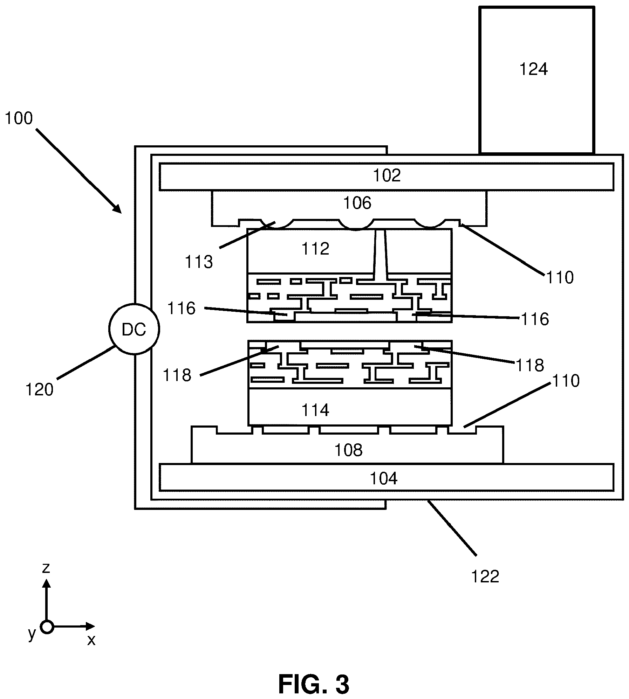

In an embodiment illustrated in Figure 3, a stacking device 100 includes a top stage 102 and a bottom stage 104. The stages 102, 104 are movable relative to one another. That is, one or both stages may be moved in six degrees of freedom, i.e., the x-, y-, and z-directions, and in the corresponding rotations rₓ, r_{y}, and r_{z}, though in practice one of the two may be stationary while the other is movable. Whether the top or bottom stage is movable is not critical, and either or both may be, as long as there is the ability to move them relatively in six degrees of freedom. The stacking device 100 may be located within a vacuum chamber 122 to avoid issues relating to breakdown voltage of an air dielectric in the case where electric fields between the dies are large. In this instance, a load lock system 124 for the vacuum chamber would also be included. Note that in general, where "top" and "bottom" are referenced herein, these components could be reversed. Likewise, while there may be advantages to horizontal orientations, they may be arranged in any orientation, for example, vertically.

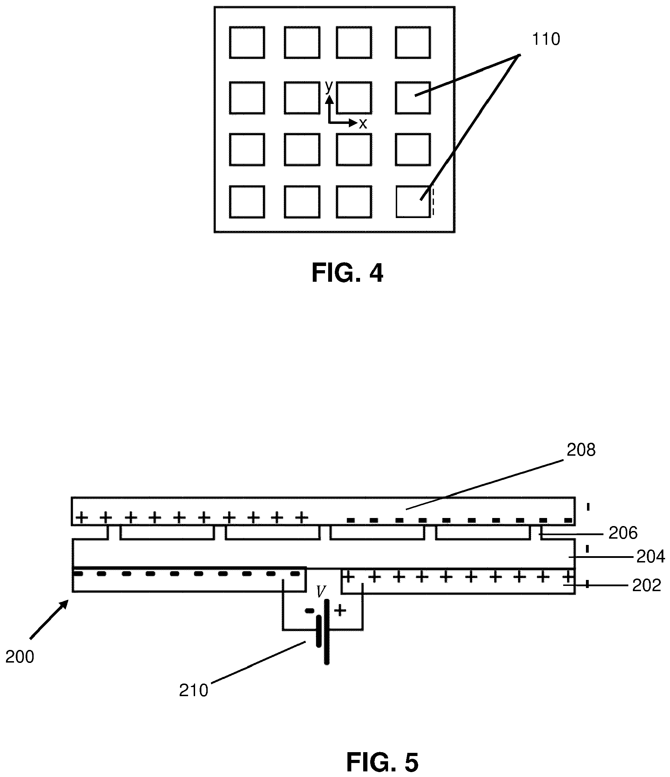

Each stage 102, 104 includes a holder 106, 108, which may include one or more pockets 110 (best seen in Figure 4), each of which is adapted to contain a respective die, wafer, or substrate. In Figure 3, each holder 106, 108 is represented by a single pocket 110. In an embodiment, each pocket is slightly larger than the die it is intended to hold. That is, the die has the dimensions on the order of a few tens, few hundreds, or few thousands of mm², and the pocket has a leeway of L µm on each side. Here L could be of the order of 1 µm or 10 µm or 100 µm. The upper holder 106 holds an upper die 112, while the lower holder 108 holds a lower die 114.

In an embodiment, the top stage 102 can be actuated in six degrees of freedom and the bottom stage is stationary. Each stage is in communication with a source of voltage (see, Figure 5) to produce an electrostatic clamping force on dies held by that stage, though any clamping approach could be substituted for electrostatic clamping. In principle, the lower stage 104 does not need an electrostatic clamp, as only the upper stage 102 is strictly required to hold its dies, as the force of gravity will retain the dies in the lower stage 104. However, to reduce a risk of the bottom die moving, it may be useful to include a clamping mechanism in the lower stage 104 as well. Such clamping could include any fixation of the bottom die, including vacuum, electrostatic clamping, sticking paper, or the like. The electrostatic clamping force may be, for example, provided as a DC voltage.

In an embodiment, the electrostatic chuck arrangement is as shown in Figure 5. The electrostatic clamp 200 portion of the stage includes a conductor layer 202 and a dielectric layer 204. The dielectric layer may include fingers or burls 206 for making contact with a reduced area of the die or wafer 208 as it is held by the chuck. A bipolar electric potential is applied to the conductor layer 202 using a DC voltage source 210. The same general structure may be used for both the top and bottom stages 102, 104. As noted above, top and bottom could be reversed, or the stages could be vertical rather than horizontal.

In each of these stages, the clamp is designed to reduce mobility of the wafer or die that is held thereby in the z-direction, in particular, where z is considered the direction perpendicular to the supporting stage. That is, the upper chuck supports an upper wafer or die and prevents it from falling, while the lower chuck supports a lower wafer or die and prevents it from being lifted by any upward forces. Moreover, the normal forces produced by the chuck enhance a frictional force between the chuck and the item supported, reducing mobility in the x- and y- directions, and in rotational directions. The pocket structure further reduces the ability of each supported item to move as well. The clamp pressure in the bottom stage can be arbitrarily high, e.g., with 3.2kV DC, a clamping pressure of 0.41 bar can be achieved over a full wafer.

As seen in Figure 3, the top stage 102 may include an array of rollers 113 instead of the fingers used on the lower side. Due to the rollers, the clamping pressure (in use) will restrain the substrate or die only in the z-direction, while the rollers allow movement of the substrate or die in a plane defined by the distal ends of the rollers, such as translation and/or rotation in the x-y plane as shown in Fig. 3. The rollers may be, for example, cylindrical rollers, or ball shaped rollers. In an embodiment, each pocket includes a set of five ball shaped rollers, one at or near each corner, and one in a central location. In another embodiment, the top stage 102 may include an array of fingers that allow the top die to slide with respect to the top stage. That is, the fingers are stiff in the z-direction, but apply a low frictional force opposing lateral movement of the die. As with the lower stage 104, the pockets restrain gross movement beyond the L µm range allowed due to the space between pocket walls and the substrate. Here L could be of the order of 1 µm or 10 µm or 100 µm.

In an embodiment, the clamp is designed to produce a clamping force. In the top stage 102 the clamping force is configured to only slightly overcome the gravitational force pulling on the supported die due to the weight of the supported die. As an example, a typical clamping force to overcome the force of gravity for a silicon based die is 0.18 mbar, and a corresponding clamping DC voltage may be somewhat less than 100 V.

A DC voltage source 120 is configured to apply an alignment voltage to each of the upper and lower dies. This alignment voltage is applied to the conductors on the dies, in order to cause a force to be generated between the upper die and the lower die to cause them to become aligned. This will be discussed in greater detail, below.

The upper die 112 and lower die 114 have respective conductive pads 116, 118, corresponding to respective electrical features of the die. It is these conductive pads 116, 118 that are to be aligned and bonded such that the stack can act as a single device. In an embodiment, the alignment method could be applied to align TSVs of one chip to pads of another chip, or to align TSVs of both chips to each other. In an alternative embodiments any of the dies may comprise conductive alignment pads which are conductive pads specifically designed and/or used for this electrostatic alignment only. In such an embodiment, the TSVs may, for example, be relatively small and better alignment may be achievable using dedicated conductive alignment pads. Such conductive alignment pads may not require bonding to create electrical connections between the two dies. Still, to enhance secure bonding between two dies, bonding may be applied to corresponding conductive alignment pads.

A voltage source 120 is arranged to apply opposing charges to the conductive pads 116, 118. In an embodiment this is an AC voltage source. In an embodiment, it may be a DC voltage source, though then the DC voltage used for clamping should be a monopolar DC source rather than the dipolar arrangement of Figure 5. Similarly, a dipolar DC voltage could be used for clamping and a separate monopolar DC voltage used for alignment.

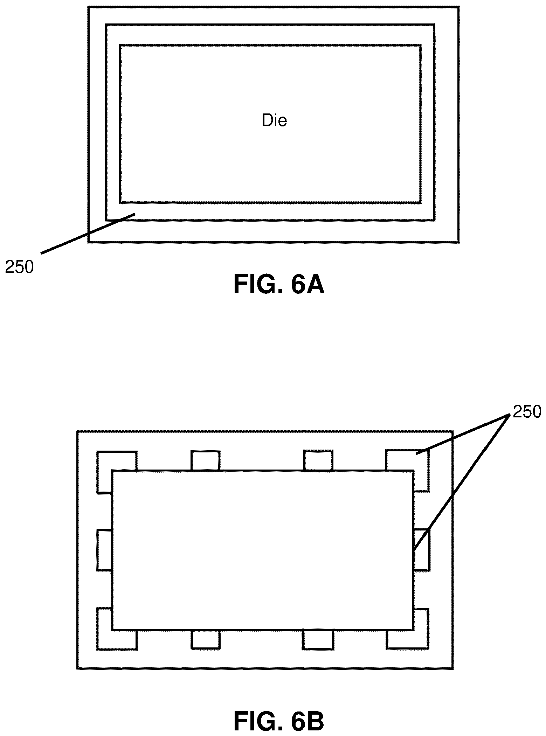

Figures 6a and 6b illustrate embodiments in which alignment markers 250 are included in a peripheral region around each die. The alignment markers 250 may be a full circumscribing line of metal, or may use broken lines as shown in Figures 6a and 6b respectively, alignment markers 250 need not be only at periphery, they can also be included within the die if there is sufficient space in the design. The alignment markers are not required but can be used to provide a coarse/fine alignment step as described further below. And, as indicated before, such alignment markers do not necessarily need to be used to bond the two dies together, but may solely be used for coarse/fine alignment. The term "alignment" herein may refer to coarse and/or fine alignment throughout this specification, except where specific reference is made to coarse alignment or fine alignment.

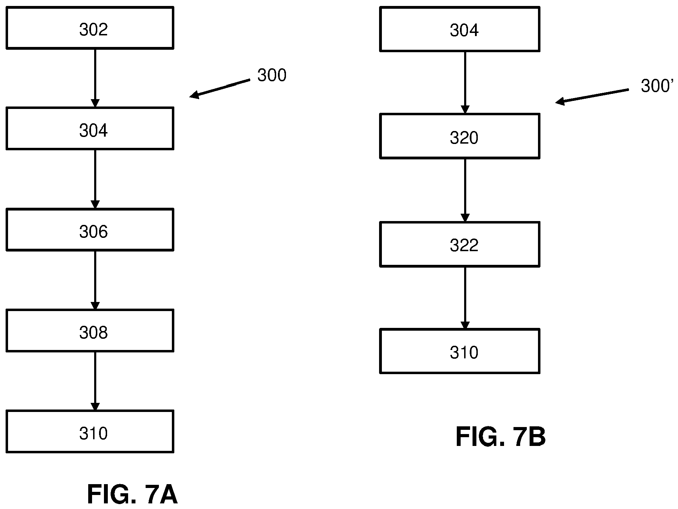

A method of aligning two items for stacking and bonding 300 will now be described with reference to the flowchart of Figure 7a. In a first step, step 302, a model-based calculation is made to determine the energy landscape. In particular, for a given configuration, the distance of separation between the two stages, a selected voltage, and a defined layout of electrical components on the dice to be bonded, there is a global minimum in the energy landscape. The complete energy landscape for each given configuration can be explored through the various relative orientations between the top/bottom stages. This landscape, the global minimum energy, and the slope of the landscape around this minimum will be determined, e.g., calculated, before the physical alignment steps are performed. Because in practice a number of identical dice are likely to be processed, the calculation step can be considered as a pre-operation step that is not necessarily required to be repeated for each stacking and bonding process. In an alternative approach, rather than model-based calculations, one or more measurements could be performed to establish the energy landscape. Typically, such an approach would, for a given layout, perform measurements for several dies, and determine an average measurement to be used for the energy landscape.

This minimum energy will be used to determine the "threshold friction" between the rollers and the die. The threshold friction will ensure that any local minima in the energy landscape will be overcome through the dragging of the rollers against the die. However, once the global minimum is reached, the rollers will be unable to move the die out-of-alignment, i.e., the die will roll freely relative to its stage, and remain in its aligned position as the stage is scanned. The determined threshold friction, and a routing of the scan pattern can be referred to as a bonding recipe operation.

In a next step 304 an upper die 112 is placed into a pocket 110 of the upper holder 106 and a lower die 114 is placed into a corresponding pocket 112 of the lower holder 108 in an appropriate orientation matching the orientation of the corresponding die. As will be appreciated, in a typical assembly operation, each respective pocket of each holder would have a die placed therein, so that an array of several dies could be simultaneously aligned and bonded.

In the event that multi-die packaging is desired, each upper pocket, for example, could have two or more items (e.g., NAND memory, DRAM or high bandwidth memory to be bonded to a common logic substrate held in the corresponding lower pocket) therein. Or a group of upper pockets could correspond to a single lower pocket, or vice versa.

This placement in the pocket results in a gross alignment equal to the leeway available in the pocket, for example L µm on a side, which means an overlay accuracy of around 2^{∗} L µm from mechanical considerations alone. Here L could be of the order of 1 µm or 10 µm or 100 µm. In order to obtain a good mechanical alignment at this stage, it is useful to ensure that the dies have been diced to a high degree of precision prior to assembly.

Next a coarse alignment step 306 is optionally performed. During this phase, the vertical distance between upper and lower stages can be reduced to a distance, for example, of 0.5mm or less, for example a range of 100 to 500µm. The metal forming the alignment markers 250 or the conducting pads has a voltage applied to it so that charge accumulates, creating an electric field between the upper and lower dies. The alignment markers 250 or the conducting pads 116,118 attract each other due to the accumulated charges, and the upper die moves in the x-y plane over its rollers in order to minimize lateral forces due to the charge accumulation, which occurs when the upper alignment markers 250 or the conducting pads 116,118 are aligned with the corresponding lower alignment markers 250 or the conducting pads 116,118.

The actual alignment step 308, also referred to as fine alignment 308, is performed by bringing the dies closer still, for example to a distance between 10µm and 100µm. During this step, the charge accumulated on the alignment markers 250 or conductive pads 116, 118 will create an even higher attractive force. The force of attraction at the perfect alignment will be sufficiently large enough to overcome the frictional force at the upper die - upper stage interface. Consequently, the upper die is held in alignment with the lower die while the top stage continues to move.

After alignment or fine alignment is completed, the parts are stacked and bonded together in step 310. In an embodiment, the electrostatic clamp of the top dies is released, and the dies fall under the force of gravity into their properly aligned positions. In an embodiment, the release may be performed over time, with a gradual reduction of the clamping force, allowing smooth motion of the dies. Other methods of bringing the dies into contact with each other could be used, including moving them together by relative movement between the stages. In one embodiment some of the alignment marks 250, conductive pads 116, 118 bond at room temperature without adhesive, under the effect of van der Waals forces. Such bonding has advantages in that any stress induced in the bonded materials is minimized. Once bonded by the van der Waals forces, inter-diffusion of the conductors may result in a stronger metallic bond. This process may be accelerated using an optional annealing step 310 at higher temperatures.

An alternate method 300' is illustrated in Figure 7b. A mechanical alignment step 304 is performed by placing the dies in their respective pockets. Following the mechanical alignment step, a capacitance is determined 320.. In this step, the top stage and bottom stage are meandered relatively to one another, and capacitance is measured. A global maximum of capacitance is determined, which corresponds to an aligned position of the dies. The gap between the stages during this measurement may be on the order of microns, tens of microns, or hundreds of microns.

Next, an actuation step 322 is performed in which each die in the top stage is individually actuated in x and y to obtain the global maximum capacitance that was determined at 320. Finally, the parts are bonded together 310.

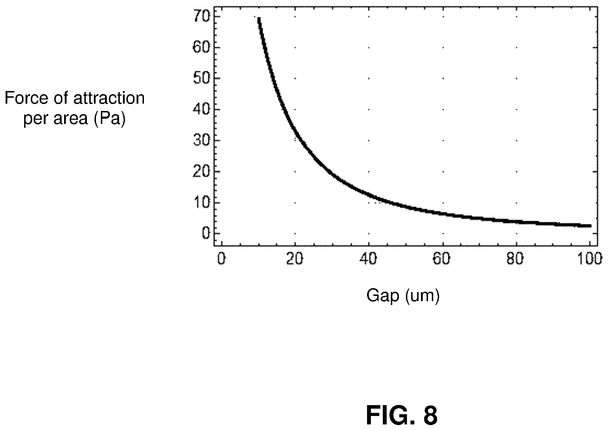

By way of example, a typical pressure due to the force of gravity for silicon is 18Pa. In order to support the top die, the clamping force must be slightly higher than the pressure due to gravity. It can be set to, for example, 25Pa, in which case the frictional force to laterally move the die on the roller balls will be µᵣ (25-18) Pa << 7 Pa because the coefficient of rolling friction µᵣ << 1. Figure 8 shows an example of 1 µm vias with 2 µm pitch, the frictional force to laterally align can be overcome by applying a voltage of 200V at a gap of 60µm or below. The force of attraction per unit area *P* ∝ *V*² and hence P can also be increased by increasing the magnitude of the applied voltage V.

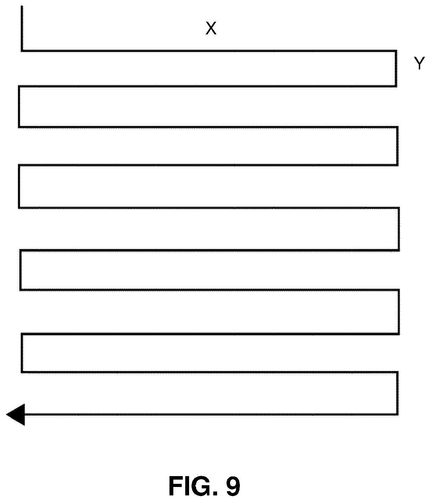

Because the overlay accuracy of the gross mechanical alignment is only 2^{∗}L µm, it is possible that the electrostatic attraction force corresponding to a lateral misalignment is too great, for the stage motion to move the die to the properly aligned orientation. For example, a local minimum energy might be encountered outside of a perfect alignment position. One approach to avoiding this is to relatively scan the stages such that the proper global minimum energy configuration is achieved, along with proper alignment of the relevant features. In the example, a meandering boustrophedonic path as shown in Figure 9 is used. While the path is shown as having a square wave shape with sharp corners, it is also possible to round the corners into a more sinusoidal shape. Using this approach will tend to result in reduced jerk because directional changes are spread over time rather than instantaneous. Because the top dies are able to move freely in the x-y plane, large jerks can cause undesirable inertial relative movement of the dies. In other embodiment, in addition to the boustrophedonic movement, the top stage might be moved with rotational degree of freedom in rx, ry and rz using actuators for individual dies to find the global minimum.

During the fine alignment 308 using alignment markers 250 and conductive pads 116, 118, a pattern of n horizontal strokes (n/2 out and n/2 back) is completed in which each long stroke in x covers a distance of about 2^{∗}L µm, and each corresponding short stroke in y covers s µm, where L is the leeway in the pocket and s is the bonding precision that is required, typically s is half the size of the conducting vias/pads. The number of strokes n is of the order of L/s. In this manner, a region of 2^{∗}Lµm × 2^{∗}Lµm area is scanned. Once alignment is achieved, the top die will remain fixed relative to the bottom die, even as the stages are relatively scanned.

Embodiments may include computer readable medium programmed with instructions, which when executed, perform any of the methods described herein. Furthermore, aspects of the present application may take the form of a computer program product embodied in any one or more physical computer readable medium(s) having computer usable program code embodied thereon.

Any combination of one or more computer readable medium(s) may be utilized. The computer readable medium may be a computer readable signal medium or a computer readable storage medium. A computer readable storage medium may be, for example, but not limited to, an electronic, magnetic, optical, electromagnetic, infrared, or semiconductor system, apparatus, device, or any suitable combination of the foregoing. More specific examples (a non-exhaustive list) of the computer readable medium would include the following: an electrical connection having one or more wires, a portable computer diskette, a hard disk, a random access memory (RAM), a read-only memory (ROM), an erasable programmable read-only memory (e.g. EPROM or Flash memory), an optical fiber, a portable compact disc read-only memory CDROM, an optical storage device, a magnetic storage device, or any suitable combination of the foregoing. In the context of this document, a computer readable storage medium may be any tangible medium that can contain or store a program for use by or in connection with an instruction execution system, apparatus, or device.

The computer program instructions may also be loaded onto a computer, other programmable data processing apparatus, or other devices to cause a series of operational steps to be performed on the computer, other programmable apparatus, or other devices to produce a computer implemented process such that the instructions which execute on the computer or other programmable apparatus provide processes for implementing the functions/acts specified in the flowchart and/or block diagram block or blocks.

A data processing system suitable for storing and/or executing program code will include at least one processor coupled directly or indirectly to memory elements through a system bus. The memory elements can include local memory employed during actual execution of the program code, bulk storage, and cache memories which provide temporary storage of at least some program code in order to reduce the number of times code must be retrieved from bulk storage during execution.

Input/output or I/O devices (including but not limited to keyboards, displays, pointing devices, etc.) can be coupled to the system either directly or through intervening I/O controllers. Network adapters may also be coupled to the system to enable the data processing system to become coupled to other data processing systems or remote printers or storage devices through intervening private or public networks. Modems, cable modems and Ethernet cards are just a few of the currently available types of network adapters.

Embodiments of the disclosure are defined in the following numbered clauses.

Claus 1: a device for aligning and placing electrical components comprising:
a first stage, the first stage configured and arranged to support in use at least one first electrical component, each first electrical component having a plurality of conductive surfaces on a side distal from the first stage;
a second stage, the second stage configured and arranged to support at least one second electrical component, each second electrical component having a plurality of conductive surfaces on a side distal from the second stage;
a voltage source, configured and arranged to produce a voltage between the conductive surfaces of the first electrical components and conductive surfaces of the second electrical components;
a controller, configured and arranged to control relative motion between the first stage and the second stage, and to align corresponding ones of the plurality of conductive surfaces of the first electrical component with corresponding ones of the plurality of conductive surfaces on the second electrical component at least partially on the basis of an electrostatic force therebetween.

Clause 2: a device as in clause 1, wherein the first stage is configured and arranged to support the at least one first electrical component using a plurality of rollers, the rollers providing freedom of motion to the at least one first electrical component in a direction substantially parallel to the first stage.

Clause 3: a device as in clause 1, wherein the first stage is configured and arranged to support the at least one first electrical component using a plurality of fingers, the fingers providing freedom of motion to the at least one first electrical component in a direction substantially parallel to the first stage.

Clause 4: a device as in any of clauses 1 to 3, wherein the first stage supports the at least one first electrical component with a first clamp and the second stage supports the at least one second electrical component with a second clamp.

Clause 5: a device as in clause 4, wherein the controller further controls a clamping force of the first clamp of the first stage to a threshold value, the threshold value of clamping force being selected such that a friction force between the first stage and the at least one first electrical component allows for substantially free movement relative to one another when the conductive surfaces of the at least one first electrical component and the conductive surfaces of the at least one second electrical component are aligned.

Clause 6: a device as in clause 4 or 5, wherein the controller is further configured to release the first clamp after aligning the at least one first electrical component with the at least one second electrical component.

Clause 7: a device as in any of clauses 1 to 6, wherein the stages are configured and arranged for relative movement between the at least one first electrical components and the at least one second electrical components in a boustrophedonic pattern.

Clause 8: a device as in clause 7, wherein corners of the boustrophedonic pattern are rounded.

Clause 9: a device as in any of clauses 1 to 8, wherein the stages are configured for relative movement between the at least one first electrical component and the at least one second electrical component in six degrees of freedom.

Clause 10: a device as in any of clauses 1 to 9, wherein the first stage includes at least one pocket sized to accommodate a respective one of the at least one first electrical component.

Clause 11: a device as in any of clauses 1 to 10, wherein the second stage includes at least one pocket sized to accommodate a respective one of the at least one second electrical components.

Clause 12: a device as in any of clauses 1 to 9, wherein the first stage includes at least one first pocket sized to accommodate a respective one of the at least one first electrical component and the second stage includes at least one second pocket sized to accommodate a respective one of the at least one second electrical component, wherein the first and second pockets are configured to provide an initial mechanical alignment between the at least one first electrical component and the at least one second electrical component.

Clause 13: a device as in any of clauses 1 to 12, further comprising a vacuum chamber containing the first and second stages, the vacuum chamber being configured to provide a reduced pressure environment for the aligning and placing.

Clause 14: a device as in clause 13, wherein the vacuum chamber further comprises a load lock chamber providing access to the vacuum chamber.

Clause 15: a device as in any of clauses 1 to 14, wherein the voltage source is a DC voltage source.

Clause 16: a method of aligning and placing electrical components using a first stage supporting at least one first electrical component and a second stage supporting at least one second electrical component, each first electrical component having at least one conductive surface on a side distal from the first stage and each second electrical component having a at least one conductive surface on a side distal from the second stage, the method comprising:
applying a voltage between the at least one conductive surface of the at least one first electrical component and the at least one conductive surface of the at least one second electrical component;
controlling relative motion between the first stage and the second stage, to perform an alignment between corresponding ones of the conductive surfaces on the basis of an electrostatic force therebetween.

Clause 17: a method as in clause 16, comprising:
mechanically aligning the at least one first electrical component to the at least one second electrical component to a first degree of alignment;
applying a voltage between a first alignment conductive surface of the at least one first electrical component and a second alignment conductive surface of the at least one second electrical component, and performing a coarse alignment to a second degree of alignment, on the basis of an alignment electrostatic force therebetween, wherein the second degree of alignment is more precise than the first degree of alignment, and wherein the performing the coarse alignment is performed after the mechanically aligning, and wherein the alignment is performed to a third degree of alignment, more precise than the second degree of alignment and after the performing the coarse alignment.

Clause 18: a method as in either of clauses 16 or 17, further comprising, after performing the alignment, moving the at least one first electrical component and the at least one second electrical component relative to one another to bring them into contact with each other to bond the first electrical component to the second electrical component.

Clause 19: a method as in any of clauses 16 to 18, further comprising, prior to the applying a voltage, placing the at least one first electrical component and the at least one second electrical component into a vacuum environment.

Clause 20: a method as in any of clauses 16 to 19, wherein the applying the voltage comprises applying a DC voltage.

The description of the present application has been presented for purposes of illustration and description, and is not intended to be exhaustive or limited to the invention in the form disclosed. Many modifications and variations will be apparent to those of ordinary skill in the art. The embodiment was chosen and described in order to best explain the principles of the invention, the practical application, and to enable others of ordinary skill in the art to understand the invention for various embodiments with various modifications as are suited to the particular use contemplated.

Though the above discussion has been largely centered on die-to-die stacking and bonding operations, the principles of operation described herein may be applied equally to wafer-to-wafer bonding, or collective die-to-wafer bonding, for example.

Although specific reference may be made in this text to the manufacture of ICs, it should be explicitly understood that the description herein has many other possible applications. For example, it may be employed in the manufacture of integrated optical systems, guidance and detection patterns for magnetic domain memories, liquid crystal display panels, thin film magnetic heads, etc. The skilled artisan will appreciate that, in the context of such alternative applications, any use of the terms "reticle", "wafer" or "die" in this text should be considered as interchangeable with the more general terms "mask", "substrate" and "target portion", respectively.

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The terms "optimizing" and "optimization" as used herein refers to or means adjusting a patterning apparatus (e.g., a lithography apparatus), a patterning process, etc. such that results and/or processes have more desirable characteristics, such as higher accuracy of projection of a design pattern on a substrate, a larger process window, etc. Thus, the term "optimizing" and "optimization" as used herein refers to or means a process that identifies one or more values for one or more parameters that provide an improvement, e.g. a local optimum, in at least one relevant metric, compared to an initial set of one or more values for those one or more parameters. "Optimum" and other related terms should be construed accordingly. In an embodiment, optimization steps can be applied iteratively to provide further improvements in one or more metrics.

While the concepts disclosed herein may be used for imaging on a substrate such as a silicon wafer, it shall be understood that the disclosed concepts may be used with any type of lithographic imaging systems, e.g., those used for imaging on substrates other than silicon wafers.

The descriptions above are intended to be illustrative, not limiting. Thus, it will be apparent to one skilled in the art that modifications may be made as described without departing from the scope of the claims set out below.

## Claims

1. A device for aligning and placing electrical components comprising:
a first stage, the first stage configured and arranged to support in use at least one first electrical component, each first electrical component having a plurality of conductive surfaces on a side distal from the first stage;
a second stage, the second stage configured and arranged to support at least one second electrical component, each second electrical component having a plurality of conductive surfaces on a side distal from the second stage;
a voltage source, configured and arranged to produce a voltage between the conductive surfaces of the first electrical components and conductive surfaces of the second electrical components;
a controller, configured and arranged to control relative motion between the first stage and the second stage, and to align corresponding ones of the plurality of conductive surfaces of the first electrical component with corresponding ones of the plurality of conductive surfaces on the second electrical component at least partially on the basis of an electrostatic force therebetween.

2. A device as in claim 1, wherein the first stage is configured and arranged to support the at least one first electrical component using a plurality of rollers, the rollers providing freedom of motion to the at least one first electrical component in a direction substantially parallel to the first stage.

3. A device as in claim 1, wherein the first stage is configured and arranged to support the at least one first electrical component using a plurality of fingers, the fingers providing freedom of motion to the at least one first electrical component in a direction substantially parallel to the first stage.

4. A device as in any of claims 1 to 3, wherein the first stage supports the at least one first electrical component with a first clamp and the second stage supports the at least one second electrical component with a second clamp.

5. A device as in claim 4, wherein the controller further controls a clamping force of the first clamp of the first stage to a threshold value, the threshold value of clamping force being selected such that a friction force between the first stage and the at least one first electrical component allows for substantially free movement relative to one another when the conductive surfaces of the at least one first electrical component and the conductive surfaces of the at least one second electrical component are aligned.

6. A device as in claim 4 or 5, wherein the controller is further configured to release the first clamp after aligning the at least one first electrical component with the at least one second electrical component.

7. A device as in any of claims 1 to 6, wherein the stages are configured and arranged for relative movement between the at least one first electrical components and the at least one second electrical components in a boustrophedonic pattern.

8. A device as in any of claims 1 to 7, wherein the stages are configured for relative movement between the at least one first electrical component and the at least one second electrical component in six degrees of freedom.

9. A device as in any of claims 1 to 8, wherein the first stage includes at least one pocket sized to accommodate a respective one of the at least one first electrical component.

10. A device as in any of claims 1 to 9, wherein the second stage includes at least one pocket sized to accommodate a respective one of the at least one second electrical components.

11. A device as in any of claims 1 to 8, wherein the first stage includes at least one first pocket sized to accommodate a respective one of the at least one first electrical component and the second stage includes at least one second pocket sized to accommodate a respective one of the at least one second electrical component, wherein the first and second pockets are configured to provide an initial mechanical alignment between the at least one first electrical component and the at least one second electrical component.

12. A device as in any of claims 1 to 11, further comprising a vacuum chamber containing the first and second stages, the vacuum chamber being configured to provide a reduced pressure environment for the aligning and placing.

13. A device as in claim 12, wherein the vacuum chamber further comprises a load lock chamber providing access to the vacuum chamber.

14. A device as in any of claims 1 to 13, wherein the voltage source is a DC voltage source.

15. A method of aligning and placing electrical components using a first stage supporting at least one first electrical component and a second stage supporting at least one second electrical component, each first electrical component having at least one conductive surface on a side distal from the first stage and each second electrical component having a at least one conductive surface on a side distal from the second stage, the method comprising:
applying a voltage between the at least one conductive surface of the at least one first electrical component and the at least one conductive surface of the at least one second electrical component;
controlling relative motion between the first stage and the second stage, to perform an alignment between corresponding ones of the conductive surfaces on the basis of an electrostatic force therebetween.
